# EUROPEAN PATENT SPECIFICATION

(11) **EP 4 595 085 B1**
(45) Date of publication and mention of the grant of the patent: **26.11.2025**
(21) Application number: 23772535.3
(22) Date of filing: 25.09.2023
(51) Int. Cl.: H01F 6/06, H01F 27/30

(54) **USE OF SUPERCONDUCTOR WIRE FOR ELECTRICYLL CONNNECTING ADJACENT FIELD COILS IN A MAGNETIC RESONANCE IMAGING CRYOSTAT**
VERWENDUNG EINES SUPRALEITERDRAHTS ZUR ELEKTRISCHEN VERBINDUNG BENACHBARTER FELDSPULEN IN EINEM MAGNETRESONANZBILDGEBUNGSKRYOSTAT
UTILISATION D'UN FIL SUPRACONDUCTEUR POUR LA CONNEXION ÉLECTRIQUE DE BOBINES DE CHAMP ADJACENTES DANS UN CRYOSTAT D'IMAGERIE PAR RÉSONANCE MAGNÉTIQUE

(30) Priority: 30.09.2022 EP 22198939
(43) Date of publication of application: 06.08.2025
(73) Proprietor: Koninklijke Philips N.V., 5656 AG Eindhoven (NL)
(72) Inventor: FORTHMANN, Peter, 5656 AG Eindhoven (NL)
(74) Representative: Philips Intellectual Property & Standards
(86) International application number: PCT/EP2023/076313
(87) International publication number: WO 2024/068493

(56) References cited:
- CN-A- 109 102 986
- DE-A1- 102018 213 598
- JP-A- H0 765 646
- BALLARINO A ET AL: "Journal of Physics: Conference Series Status of MgB 2 wire and cable applications in Europe Status of MgB2 wire and cable applications in Europe", J. PHYS.: CONF. SER. JOURNAL OF PHYSICS: CONF. SERIES, vol. 871, no. 871, 1 January 2017 (2017-01-01), pages 12098, XP093027352, Retrieved from the Internet <URL:https://iopscience.iop.org/article/10.1088/1742-6596/871/1/012098/pdf>

## Description

### FIELD OF THE INVENTION

The invention relates to the field of electrically conducting wires with superconductors, and in particular to electrically conducting wires with superconductors for a magnetic resonance imaging cryostat.

### BACKGROUND OF THE INVENTION

Superconducting magnets may be used in systems that require strong magnetic fields, such as magnetic resonance imaging (MRI) and nuclear magnetic resonance (NMR) spectrometry, for example. To realize superconductivity, a magnet includes one or more electrically conductive coils, which are formed from superconducting wire. In order to maintain superconductivity for conventional superconductors, a cryogenic environment (cryostat) at a temperature near absolute zero during operation is necessary. In the superconducting state, the electrically conductive coils are referred to as superconducting coils, which effectively have no electrical resistance, and therefore conduct much larger electric currents to create strong magnetic fields. In this respect, ordinary metallic superconductors are well known, which usually work below 77 K.

There also exist high-temperature superconductors (HTS) which are operatively defined as materials that behave as superconductors at temperatures above 77 K, the boiling point of liquid nitrogen, one of the simplest coolants in cryogenics. All materials currently known to conduct at ordinary pressures become superconducting at temperatures far below ambient, and therefore require cooling. The majority of high-temperature superconductors are ceramic materials. Ceramic superconductors are becoming suitable for some practical use, but they still have many manufacturing issues and there are only few successful practical examples of employment. Most ceramics are brittle, which makes the fabrication of wires from them problematic.

Magnesium diboride (MgB₂) is a promising superconductor with a higher operating temperature than conventional NbTi conductors. MgB₂ becomes superconducting below 39 K; this is far less than the about 150 K of YBaCuO-HTC material, but still has the advantage that cooling capacity is much higher at 39 K than at 9.7 K, which is required for cooling NbTi. This relaxes many of the thermal constraints that drive the cost of a cryostat for magnetic resonance imaging (MRI cryostat). As mentioned above, one of the drawbacks of conventional MgB₂ wires, however, is that they are brittle. Bending radii below the order of 15 cm can lead to cracking and loss of function. This can be a serious limitation when routing the wire.

Manufacturing methods for MgB₂ wires are well known (see for example A. Ballarino and R. Flükiger 2017 J. Phys.: Conf. Ser. 871 012098 or M. N. Kutukcu et al., "Composite Superconducting MgB2 Wires Made by Continuous Process," in IEEE Transactions on Applied Superconductivity, vol. 28, no. 4, pp. 1-4, June 2018, Art no. 6200704). The most important methods for manufacturing MgB₂ wires are ex situ and in situ. Further, a magnesium diffusion technique exists. For example, for the ex-situ method, pre-reacted MgB₂ powders with a molar ratio of 1:2 are inserted into a Nb tube, surrounded by a Cu_{.70}Cu_{.30} tube and drawn to a wire of about 3.5 mm diameter. Several pieces of wires are then inserted in a Nickel or Monel tube, together with OFHC Cu for stabilization. This composite is groove rolled and drawn to a round wire with a diameter of 2 mm, which is twisted before to be rolled to a tape (typically 3.6 x 0.65 mm²) or to a wire of about 1 mm diameter, followed by a recrystallization heat treatment of typically 4 minutes at 965°C. For in situ MgB₂ wires, the initial MgB₂ mixture consists of Mg and B powders. This alternative has the advantage that the reaction to MgB₂ occurs at considerably lower temperatures (around 650 °C), thus reducing the reaction layer at the metallic sheath.

In J. Breitschopf et al 2020 IOP Conf. Ser.: Mater. Sci. Eng. 756 012031, results are reported in the development of 2-layer cable-in-conduit (SuperCIC) that is designed for use in hybrid-coil magnets. SuperCIC preserves the full performance of the individual wires and can be formed into flared-end windings for dipoles into layer-wound toroids and solenoids for hybrid windings for tokamaks. The structure of the SuperCIC windings is designed to accommodate winding and heat-treating sub-windings of Bi-2212, Nb₃Sn, and NbTi separately and then assembling them and preloading in the magnet.

### SUMMARY OF THE INVENTION

It is an object of the invention to provide electrically conducting wires that comprise a superconductor and that allow small bending radii, especially lower than 15 cm, when routing the wires without cracking and loss of function.

According to the invention, this object is addressed by the subject matter of the independent claims. Preferred embodiments of the invention are described in the dependent claims.

Therefore, according to the invention, an electrically conducting wire is provided, the wire being formed as a flexible helix with constant or changing slope, with constant or changing diameter, with straight or curved extension and with straight or curved extension, wherein the wire comprises a superconductor.

Usually, a helix a is defined as a curve that winds around the mantle of a cylinder which defines a diameter and with a constant slope. However, according to the present invention, also such geometries are understood to be a helix which show a changing slope and/or a changing diameter along their respective extension and/or a straight or curved extension. This means, the extension of the helix does not have to be straight as is the axis of a cylinder. Rather, the invention also allows for a curved extension of the helix which does not follow a straight line.

It is an essential aspect of the invention that bending a helix puts less stress on the individual wire turns and therefore allows smaller bend radii than allowable for a straight wire. Therefore, the electrically conducting wire according to the invention is of great advantage when routing the wire, since the risk of cracking and loss of function of the wire is considerably reduced due to the shape of the electrically conducting wire which is the shape of a flexible helix with constant or changing slope, with constant or changing diameter and with straight or curved extension. Hence, the invention makes use of the fact that the required bending moment is distributed over a longer wire length, or the bending moment is converted into torsion which is also distributed over several loops.

In general, different superconductors can be used for electrically conducting wire. However, according to a preferred embodiment of the invention, the wire comprises MgB₂ as a superconductor. As mentioned above, MgB₂ is a superconductor with a higher operating temperature than conventional NbTi conductors. MgB₂ becomes superconducting below 39 K which is far less than the about 150 K of YBaCuO-HTC material, but still has the advantage that cooling capacity is much higher at 39 K than at 9.7 K, which is required for cooling NbTi. Therefore, many of the thermal constraints that drive the cost of a cryostat for MRI cryostat may be solved in this way. The drawback of conventional MgB₂ wires, i.e., that it is brittle and may, therefore, easily crack, is overcome due the shape of a flexible helix. In this way, bending radii below 15 cm are easily achievable, which is of great advantage when routing the wire.

Different dimensions can be used for the flexible helix. However, according to a preferred embodiment of the invention, the diameter of the helix is between 1.5 cm and 8 cm, preferably between 3.5 cm and 6.5 cm. Further, it is preferred that the electrically conducting wire has a diameter of between 0.4 and 1.6 mm, preferably between 0.8 mm and 1.2 mm. Further, according to a preferred embodiment of the invention, the electrically conducting wire has a length such that the number of windings is between 6 and 12, preferably between 8 and 10, when neighboring windings are in contact with each other. For example, this means that if the diameter of the flexible helix in its relaxed state is 5 cm and the number of windings is 10, the length of the wire is approx. 157 cm.

The electrically conducting wire may have a constant winding direction which means that the windings follow the shape of a circle with a constant slope. However, according to a preferred embodiment of the invention, the winding direction of the flexible helix changes after each full turn. Here, a full turn is defined as a winding within the range of 340 ° to 380 °. In this respect, it is especially preferred that the wire is bent back by 180 ° towards its previous course after each full turn. This may be advantageous for field sensitive applications since winding portions which run antiparallel to each other may compensate each other.

According to the invention, two electrically conducting wires are provided which are formed as a double helix with alternating winding directions. This may also be advantageous for field sensitive applications since winding portions which run antiparallel to each other may compensate each other.

The invention is also directed to the use of an electrically conducting wire or an electrically conducting wire assembly as described above for electrically connecting the windings of a magnet in a magnetic resonance imaging cryostat, where, preferably, the magnet is a superconducting magnet. As mentioned above, such a use is advantageous since the routing of the wire gets easier since there is a reduced risk of breaking. In this respect, it is preferred that the electrically conducting wire or the electrically conducting wire assembly is guided via a bending that is equal or greater than 90 ° and or that comprises a bending radius of 15 cm or less.

Further, the invention is also directed to a magnet arrangement formed as an assembly for a magnetic resonance imaging apparatus, comprising a cryostat, a magnet with multiple field coils with superconductive windings arranged within the cryostat and a wire assembly with two electrically conducting wires are formed as a double helix with alternating winding directions for electrically connecting the windings of adjacent field coils of a magnet (2) in a magnetic resonance imaging cryostat (1). The invention provides for bending the helix which puts less stress on the individual wire turns and therefore allows smaller bend radii than allowable for a straight wire. Therefore, the electrically conducting wire according to the invention is of great advantage when routing the wire between adjacent field coils of the magnet tat are based on high(er) temperature superconductors, since the risk of cracking and loss of function of the wire is considerably reduced due to the shape of the electrically conducting wire which is the shape of a flexible helix with constant or changing slope, with constant or changing diameter and with straight or curved extension. Hence, the invention makes use of the fact that the required bending moment is distributed over a longer wire length or the bending moment is converted into torsion which is also distributed over several loops in the electrical connections between the adjacent superconducting field windings containing high(er) superconducting wires or strips of the field winding . Furthermore, the invention is also directed to a manufacturing method for an electrically conducting wire, comprising the following method steps:
arranging material comprising i) pre-reacted MgB₂ powder or ii) Mg powder and B powder in the form of a flexible helix with constant or changing slope and with constant or changing diameter, and
heat treating the arranged material.

In this respect, in case i) the heat treating is preferably performed at a temperature between 930 °C and 1000 °C, preferably at 965 °C, for a time between 2 min and 6 min, preferably for 4 min. Further, it is preferred that in case ii) the heat treatment is performed at a temperature between 600 °C and 750 °C, preferably at 650°C, for a time between 30 min and 50 min, preferably for 40 min.

A not claimed aspect of the present application is a manufacturing method for an electrically conducting wire, comprising the following method steps:
a) arranging a pure Mg rod at the center of a Ta or Nb tube,
b) filling the area between the area between the Mg rod and the Ta or Nb tube with B and C,
c) repeating steps a) and b) for additional Mg rods and Ta or Nb tubes,
d) bundling the filled rods,
e) inserting the bundled and filled rods into a Cu-Ni tube,
f) cold deforming the filled Cu-Ni tube in the form of a helix with constant or changing slope, with constant or changing diameter and with straight or curved extension, and
g) heat treating the arranged material.

In this respect, it is preferred that C is provided as a carbon layer on the surface of the B particles or as C₁₄H₁₂ powders. Further, the heat treatment is preferably performed in a temperature range between 630 and 650 °C, preferably at 640 °C. In this way, Mg diffuses into the B particles and reacts to form MgB₂ layers of 10 to 30 µm thickness along the inner wall of the Ta tube.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a cryostat with two electrically conducting wires which are each formed as a flexible helix,
Fig. 2 schematically depicts an electrically conducting wire assembly with two electrically conducting wires according to a preferred embodiment of the invention, wherein the two electrically conducting wires are formed as a double helix with alternating winding directions.
Fig. 3 schematically depicts an electrically conducting wire wherein the winding direction of the helix changes after each 360 ° winding,
Fig. 4 depicts the method steps of a manufacturing method for an electrically conducting wire
Fig. 5 depicts the method steps of a manufacturing method for an electrically conducting wire;
Fig. 6 shows a diagrammatic representation of a magnet (2) with multiple field coils with superconductive windings in which the helix-shaped electrical wire of the invention is incorporated.

### DETAILED DESCRIPTION OF EMBODIMENTS

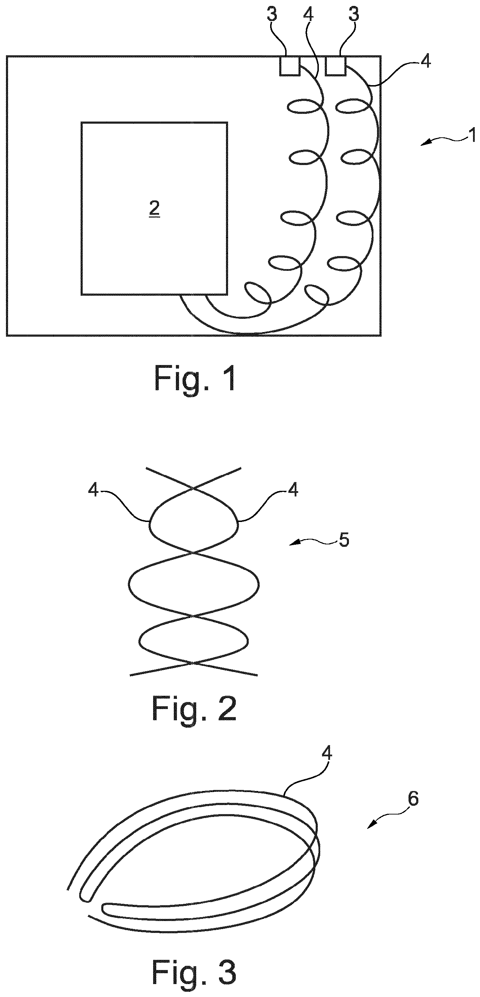

Fig. 1 schematically depicts a MRI cryostat 1 with two electrically conducting wires 4. The electrically conducting wires 4 are both formed as a flexible helix. Here, the term "flexible helix" does not only relate to such conventional helix shapes which are defined as a curve that winds around the mantle of a cylinder which defines a diameter and with a constant slope. Rather, here also such geometries are understood to be a flexible helix which show a changing slope and/or a changing diameter along their respective extension. Further, the extension of the helix does not have to be straight as is the axis of a cylinder. Rather, the invention also allows for a curved extension of the helix which does not follow a straight line.

As depicted in Fig. 1, the electrically conducting wires 4 are routed in the MRI cryostat 1 from two electric terminals 3 to a super conducting magnet 4. Though this routing of the electrically conducting wires 4 means bending the wires 4, there is only a small risk of breakage since the electrically conducting wires 4 are shaped as a flexible helix. Therefore, this example takes advantage from the fact that bending a helix instead of a straight wire puts less stress on the individual wire turns and therefore allows smaller bend radii than allowable for a straight wire. This means that the electrically conducting wires 4 may even be formed from a brittle material.

According to the preferred embodiment of the invention described here, the electrically conducting wires 4 both comprise MgB₂ as a superconductor. As mentioned above, MgB₂ becomes superconducting below 39 K which has the advantage that cooling capacity is much higher at 39 K than at 9.7 K which is required for cooling NbTi. In this way, the drawback of conventional MgB₂ wires, i.e., that they are brittle and may, therefore, easily crack, is overcome due the shape of a flexible helix.

Here, the electrically conducting wire has a diameter of the helix which is 5 cm and the electrically conducting wire 4 has a diameter which is 1 mm. Further, as can be understood from Fig. 1, the number of windings of each electrically conducting wire 4 is six.

Further, Fig. 2 schematically depicts an assembly with two electrically conducting wires 4 according to the preferred embodiment of the invention. Here, the two electrically conducting wires 4 are formed as a double helix wire assembly 5 with alternating winding directions. Since the currents in such alternating windings may compensate each other such a design is advantageous for field sensitive applications.

Fig. 3 schematically depicts an electrically conducting wire 4 according to an example which is also advantageous for field sensitive applications. Here, a helix 6 is provided wherein the winding direction of the helix 6 changes after each 360 ° winding.

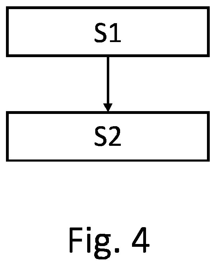

The method steps of a manufacturing method an electrically conducting wire is depicted in Fig. 4. This manufacturing method comprises the following method steps:
S1) arranging material comprising i) pre-reacted MgB₂ powder or ii) Mg powder and B powder in the form of a helix with constant or changing slope, with constant or changing diameter and with straight or curved extension, and
S2) heat treating the arranged material.

This means that this preferred embodiment of the invention allows for two alternatives, i.e., using pre-reacted MgB₂ powder or Mg powder and B powder. In both cases these materials are arranged in the form of a helix with constant or changing slope, with constant or changing diameter and with straight or curved extension. However, the heat treatment in step S2 is different for both cases. In case i), the heat treating is performed at a temperature of 965 °C for 4 min. In contrast to that, in case ii) the heat treating is performed at a temperature of 650 °C for 40 min.

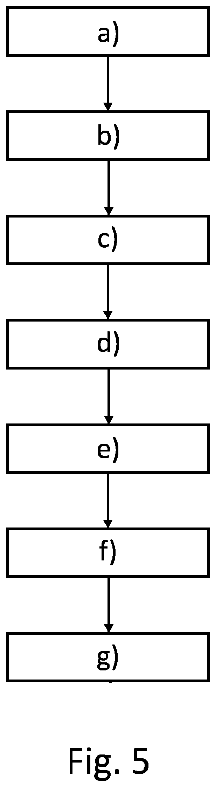

Fig. 5 depicts the method steps of another manufacturing method for an electrically conducting wire.

This method comprises the following method steps:
a) arranging a pure Mg rod at the center of a Ta or Nb tube,
b) filling the area between the area between the Mg rod and the Ta or Nb tube with B and C,
c) repeating steps a) and b) for additional Mg rods and Ta or Nb tubes,
d) bundling the filled rods,
e) inserting the bundled and filled rods into a Cu-Ni tube,
f) cold deforming the filled Cu-Ni tube in the form of a helix with constant or changing slope, with constant or changing diameter and with straight or curved extension, and
g) heat treating the arranged material.

Here, C is provided as a carbon layer on the surface of the B particles or as C₁₄H₁₂ powders. Further, the heat treatment is performed at 640 °C. In this way, Mg diffuses into the B particles and reacts to form MgB₂ layers of 10 to 30 µm thickness along the inner wall of the Ta tube.

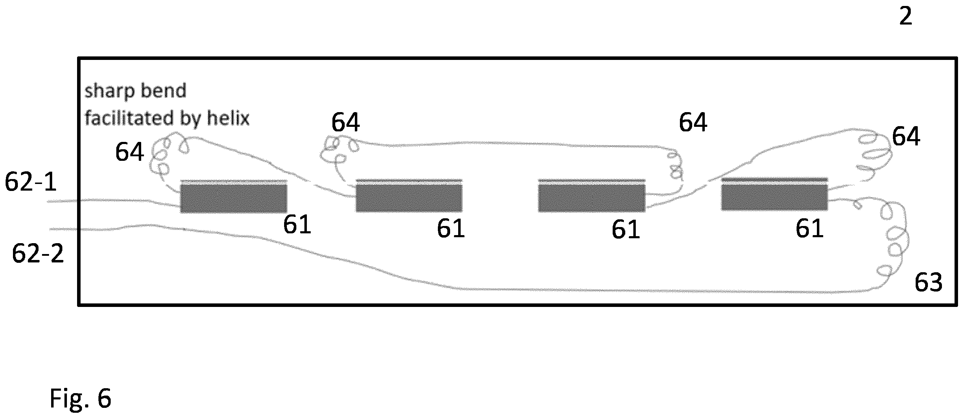

Figure 6 shows a diagrammatic representation of a magnet (2) with multiple field coils with superconductive windings in which the helix-shaped electrical wire of the invention is incorporated. The magnet 2 includes several field coils 61, each of them containing windings of superconducting material, e.g., including MgB2 in a matrix of normal resistive metal. Electrical feeding connections 62-1, 62-2 is provided for connecting to a power supply outside of the magnet, and even outside the cryostat 1. A helix-shaped electrical wire 63 is provided between one of the feeding connections 62-2 and an outer field coil 61. Also, helix-shaped interconnects 64 are provided between adjacent field coil 61 to facilitate wire routing of mechanically brittle electrical connections between the field coils 61.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

- MRI cryostat: 1
- magnet: 2

- electrical terminals: 3
- superconducting wire: 4
- double helix wire assembly: 5
- helix with changing winding directions: 6

## Claims

1. Use of a wire assembly with two electrically conducting wires (4), wherein the two electrically conducting wires are formed as a double helix (5) with alternating winding directions for electrically connecting the windings of adjacent field coils, each comprising electrically conducting or superconductive windings of a magnet arrangement (2) in a magnetic resonance imaging cryostat (1).

2. Use according to claim 1, wherein the electrically conducting wire or the electrically conducting wire assembly is guided via a bending that is equal or greater than 90 ° and/or that comprises a bending radius of 15 cm or less.

3. A magnet arrangement for a magnetic resonance imaging apparatus, comprising.
a cryostat (1), a magnet (2) with multiple field coils with electrically conducting or superconductive windings arranged within the cryostat (1) and a wire assembly with two electrically conducting wires (4), wherein the two electrically conducting wires are formed as a double helix (5) with alternating winding directions for electrically connecting the windings of adjacent field coils, each comprising electrically conducting or superconductive windings of a magnet (2) in a magnetic resonance imaging cryostat (1).

4. Assembly for a magnetic resonance imaging apparatus according to claim 3, wherein the wire (4) comprises MgB₂ as a superconductor.

5. Assembly for a magnetic resonance imaging apparatus according to claim 3 or 4, wherein the diameter of the helix is between 1.5 cm and 8 cm, preferably between 3.5 cm and 6.5 cm.

6. Assembly for a magnetic resonance imaging apparatus according to any of the previous claims, wherein the diameter of the wire (4) is between 0.4 and 1.6 mm, preferably between 0.8 mm and 1.2 mm.

7. Assembly for a magnetic resonance imaging apparatus according to any of the previous claims, wherein the wire (4) has a length such that the number of windings is between 6 and 12, preferably between 8 and 10, when neighboring windings are in contact with each other.

## Patentansprüche

1. Verwendung einer Drahtanordnung mit zwei elektrisch leitenden Drähten (4), wobei die beiden elektrisch leitenden Drähte als eine Doppelhelix (5) mit abwechselnden Wicklungsrichtungen gebildet sind, um die Wicklungen angrenzender Feldspulen elektrisch zu verbinden, die jeweils elektrisch leitende oder supraleitende Wicklungen einer Magnetanordnung (2) in einem Magnetresonanztomographie-Kryostaten (1) umfassen.

2. Verwendung nach Anspruch 1, wobei der elektrisch leitende Draht oder die elektrisch leitende Drahtanordnung über eine Biegung geführt wird, die gleich oder größer als 90° ist und/oder einen Biegeradius von 15 cm oder weniger umfasst.

3. Magnetanordnung für ein Magnetresonanztomographie-Einrichtung, umfassend:
einen Kryostaten (1), einen Magneten (2) mit mehreren Feldspulen mit elektrisch leitenden oder supraleitenden Wicklungen, die innerhalb des Kryostaten (1) angeordnet sind, und eine Drahtanordnung mit zwei elektrisch leitenden Drähten (4), wobei die beiden elektrisch leitenden Drähte als eine Doppelhelix (5) mit abwechselnden Wicklungsrichtungen gebildet sind, um die Wicklungen angrenzender Feldspulen elektrisch zu verbinden, die jeweils elektrisch leitende oder supraleitende Wicklungen eines Magneten (2) in einem Magnetresonanztomographie-Kryostaten (1) umfassen.

4. Anordnung für eine Magnetresonanztomographie-Einrichtung nach Anspruch 3, wobei der Draht (4) MgB₂ als einen Supraleiter umfasst.

5. Anordnung für eine Magnetresonanztomographie-Einrichtung nach Anspruch 3 oder 4, wobei der Durchmesser der Helix zwischen 1,5 cm und 8 cm, bevorzugt zwischen 3,5 cm und 6,5 cm beträgt.

6. Anordnung für eine Magnetresonanztomographie-Einrichtung nach einem der vorstehenden Ansprüche, wobei der Durchmesser des Drahts (4) zwischen 0,4 und 1,6 mm, bevorzugt zwischen 0,8 mm und 1,2 mm beträgt.

7. Anordnung für eine Magnetresonanztomographie-Einrichtung nach einem der vorstehenden Ansprüche, wobei der Draht (4) eine solche Länge aufweist, dass die Anzahl von Wicklungen zwischen 6 und 12, bevorzugt zwischen 8 und 10 liegt, wenn benachbarte Wicklungen einander berühren.

## Revendications

1. Utilisation d'un ensemble de fils avec deux fils électriquement conducteurs (4), dans laquelle les deux fils électriquement conducteurs sont formés comme une double hélice (5) avec des directions d'enroulement alternées pour connecter électriquement les enroulements de bobines de champ adjacentes, chacune comprenant des enroulements électriquement conducteurs ou supraconducteurs d'un agencement d'aimant (2) dans un cryostat d'imagerie par résonance magnétique (1).

2. Utilisation selon la revendication 1, dans laquelle le fil électriquement conducteur ou l'ensemble de fils électriquement conducteurs est guidé par l'intermédiaire d'une courbure qui est égale ou supérieure à 90° et/ou qui comprend un rayon de courbure de 15 cm ou moins.

3. Agencement d'aimant pour un appareil d'imagerie par résonance magnétique, comprenant
un cryostat (1), un aimant (2) avec de multiples bobines de champ avec des enroulements électriquement conducteurs ou supraconducteurs agencés au sein du cryostat (1) et un ensemble de fils avec deux fils électriquement conducteurs (4), dans laquelle les deux fils électriquement conducteurs sont formés comme une double hélice (5) avec des directions d'enroulement alternées pour connecter électriquement les enroulements de bobines de champ adjacentes, chacune comprenant des enroulements électriquement conducteurs ou supraconducteurs d'un aimant (2) dans un cryostat d'imagerie par résonance magnétique (1).

4. Ensemble pour un appareil d'imagerie par résonance magnétique selon la revendication 3, dans lequel le fil (4) comprend du MgB₂ en tant que supraconducteur.

5. Ensemble pour un appareil d'imagerie par résonance magnétique selon la revendication 3 ou 4, dans lequel le diamètre de l'hélice est entre 1,5 cm et 8 cm, de préférence entre 3,5 cm et 6,5 cm.

6. Ensemble pour un appareil d'imagerie par résonance magnétique selon l'une quelconque des revendications précédentes, dans lequel le diamètre du fil (4) est entre 0,4 mm et 1,6 mm, de préférence entre 0,8 mm et 1,2 mm.

7. Ensemble pour un appareil d'imagerie par résonance magnétique selon l'une quelconque des revendications précédentes, dans lequel le fil (4) présente une longueur telle que le nombre d'enroulements est entre 6 et 12, de préférence entre 8 et 10, lorsque des enroulements voisins sont en contact les uns avec les autres.
